# EUROPEAN PATENT SPECIFICATION

(11) **EP 2 158 616 B1**
(45) Date of publication and mention of the grant of the patent: **21.06.2017**
(21) Application number: 08744754.6
(22) Date of filing: 31.03.2008
(51) Int. Cl.: H01L 31/054

(54) **CONCENTRATING PHOTOVOLTAIC KALEIDOSCOPE AND METHOD**
KONZENTRIERENDES PHOTOVOLTAISCHES KALEIDOSKOP UND VERFAHREN
KALÉIDOSCOPE ET PROCÉDÉ À CONCENTRATION PHOTOVOLTAÏQUE

(30) Priority: 10.04.2007 US 733544
(43) Date of publication of application: 03.03.2010
(73) Proprietor: Raytheon Company, Waltham, MA 02451-1449 (US)
(72) Inventor: JENKINS, David G., Tucson, AZ 85750 (US)
(74) Representative: Jackson, Richard Eric
(86) International application number: PCT/US2008/058875
(87) International publication number: WO 2008/124362

(56) References cited:
- US-A- 3 490 950
- US-A- 4 313 024
- US-A1- 2003 213 514
- US-A1- 2004 079 358
- DAVIES P A ET AL: "CALCULATIONS OF EFFICIENCIES ACHIEVABLE USING GALLIUM ARSENIDE AND SILICON CELLS MOUNTED TOGETHER IN CAVITIES ILLUMINATED BY SINGLE-STAGE CONCENTRATION" SOLAR ENERGY MATERIALS AND SOLAR CELLS, ELSEVIER SCIENCE PUBLISHERS, AMSTERDAM, NL, vol. 26, no. 3, 1 April 1992 (1992-04-01), pages 203-215, XP000274201 ISSN: 0927-0248
- LUQUE A ET AL: "OPTICAL ASPECTS IN PHOTOVOLTAIC ENERGY CONVERSION" SOLAR CELLS, ELSEVIER SEQUOIA.S.A. LAUSANNE, CH, vol. 31, no. 3, 1 June 1991 (1991-06-01), pages 237-258, XP000205658

## Description

### Field of the Invention

This invention generally relates to a system and a method for conversion of light to electricity using photovoltaic cells, and more particularly, to a concentrating photovoltaic collection system and method.

### Background

Photovoltaic cells, commonly referred to as PV cells or solar cells, convert incident light into electricity. Solar cells tend to be relatively expensive to produce relative to the amount of electricity generated. The amount of electricity generated by the solar cell is proportional to the amount of light incident on the solar cell, however, so methods of concentrating the light onto the solar cells have been employed to increase the amount of light incident on the solar cells to increase the electrical power generated per solar cell. The concentrators, such as lenses and concentrating reflectors, tend to be relatively inexpensive in comparison to the solar cells.

U.S. Patent No. 6,689,949, for example, discloses a system that concentrates light using a parabolic dish reflector as a primary concentrator, a sapphire secondary concentrator and an injector into a hollow, faceted sphere. The inside surfaces of the sphere include solar cells mounted thereto to absorb the light and convert it into electricity.

Solar cells typically are best at converting a range of wavelengths of light into electricity. Wavelengths outside this optimum band are not converted as efficiently and contribute more heat to the solar cell. Consequently, some solar concentrating collectors employ elaborate cooling systems to keep the solar cells cool. The cooling systems increases the cost and complexity of the system, however. In the system described in the '949 patent, spectral filters in front of the solar cells reflect unwanted wavelengths thereby minimizing the wavelengths that will contribute relatively more to heating the solar cell than being efficiently converted to electricity. The '949 patent intends for the reflected wavelengths to be repeatedly reflected until incident on a different type of solar cell, one that is more efficient at converting that wavelength of light into electricity. Patent publication US 2004/079358 A1, see fig. 6, discloses a solar energy converter comprising a cylindrical chamber having an input aperture 51 in the centre of one circular end face 52. The internal walls of the solar collector are provided with photovoltaic cells for the conversion of solar energy incident through the input aperture 51. Solar energy entering the solar converter via the input aperture 51 undergoes multiple reflections within the chamber 50 before being converted. In addition, the inside of the chamber 50 may be provided with wavelength-converting means, for example to convert the wavelength of the solar energy into a wavelength more suitable for absorption by photovoltaic cells.

### Summary

This invention provides a concentrating photovoltaic collection system as defined in claim 1. In particular, our invention provides a concentrating photovoltaic collection system comprising a concentrator that focuses light from a source on a focal point, and a photovoltaic box collector at approximately the focal point of the concentrator. The photovoltaic collector has a triangular, square, or hexagonal front wall, a corresponding back wall and a plurality of either interconnecting specularly reflective side walls that form a kaleidoscope. A hole in the front wall lets the light in, and a combination of reflective surfaces and photovoltaic cells reflects the light in the collector, provides uniform illumination on the photovoltaic cells and consequent efficient conversion of the light into electricity. As will be apparent,
the photovoltaic collector has a geometry that is easily and inexpensively constructed without tight tolerances.

More particularly, an exemplary concentrating photovoltaic collection system comprises a concentrator that focuses incident light at a focal point spaced from the concentrator, and a photovoltaic box collector approximately at the focal point that converts the light into electricity. The collector has a front wall and a plurality of side walls connected to sides of the front wall. The front wall has a hole for the transmission of light into the box, and the inner surfaces of the side walls are specularly reflective. The collector also includes at least one photovoltaic cell on an inside surface of the front wall to receive reflected light and convert it into electricity.

In particular, the front wall is either triangular, square, or hexagonal, including an equilateral triangle and a regular hexagon.

The inside surface of the front wall typically is tiled with photovoltaic cells to substantially completely cover the inside surface of the front wall. The inside surface of the back wall has at least one photovoltaic cell, and the inside surface of the back wall typically will be tiled with photovoltaic cells to substantially completely cover the inside surface of the back wall. Moreover, a spectral filter may be mounted over the photovoltaic cell to pass a limited set of wavelengths of light to the photovoltaic cell and to reflect other wavelengths.

A specific embodiment provided by the present invention includes a concentrating photovoltaic collection system having a parabolic reflector and a photovoltaic collector box. The collector has a front wall, a back wall, and a plurality of side walls connecting the front wall and the back wall. The front wall has a hole at the focal point of the parabolic reflector for the transmission of light into the box, and at least one photovoltaic cell is mounted to each of an inside surface of the front wall and an inside surface of the back wall to receive light and convert it to electricity. The inside surfaces of the side walls are specularly reflective, and the photovoltaic cells cover substantially the entire area of the inside surfaces of the front and back walls. The photovoltaic cells include at least two different types of photovoltaic cells that convert different wavelengths of light into electricity, and the photovoltaic cells are covered by spectral bandpass filters that transmit wavelengths within a range of wavelengths to each photovoltaic cell and reflect wavelengths outside of that range. Additionally, the front wall and the back wall have substantially the same size, shape, and orientation, the shape being either triangular, square, or hexagonal.

The foregoing and other features of the invention are hereinafter fully described and particularly pointed out in the claims, the following description and the annexed drawings setting forth in detail one or more illustrative embodiments of the invention. These embodiments, however, are but a few of the various ways in which the principles of the invention can be employed. Other objects, advantages and features of the invention will become apparent from the following detailed description of the invention when considered in conjunction with the drawings.

### Brief Description of the Drawings

FIG. 1 is a schematic representation of a concentrating photovoltaic collection system provided by the present invention.
FIGS. 2-4 are schematic perspective views of different embodiments of a photovoltaic collector for the system of FIG. 1.
FIG. 5 is a concentrating photovoltaic collector not being part of the invention.
FIG. 6 is a schematic cross-sectional view of an exemplary embodiment of a concentrating photovoltaic collection system provided by the present invention.
FIGS. 7 and 8 are alternative plan views of an inside surface of a front wall of the photovoltaic collector of FIG. 2.
FIG. 9 is a graphical representation of the uniformity of illumination of a back wall of a photovoltaic collector of the type shown in FIG. 2 for collectors with different lengths.

### Detailed Description

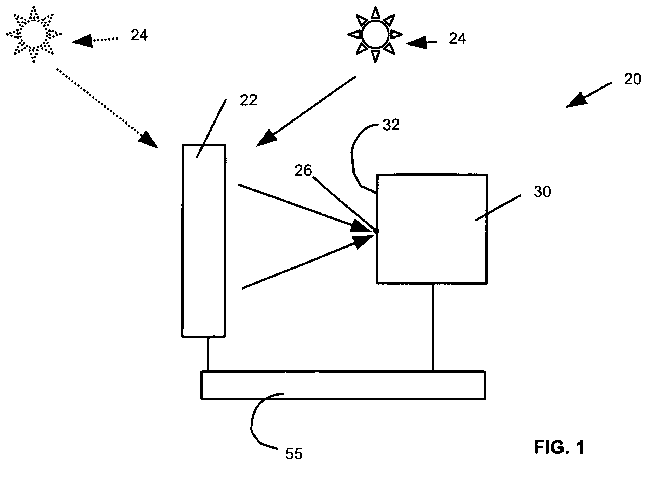

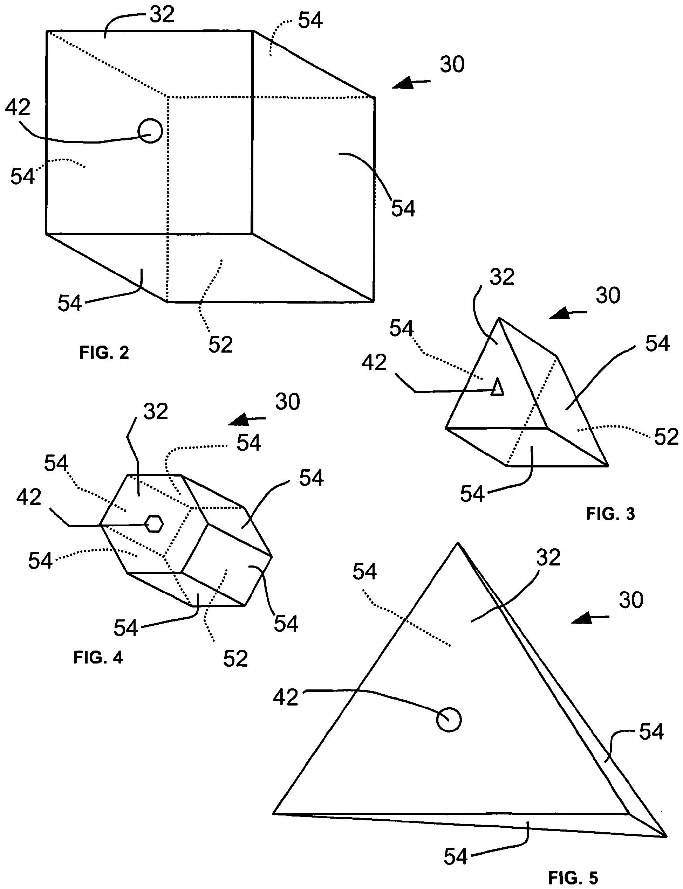

Referring now to the drawings in detail, and initially to Fig. 1-4, our invention provides a concentrating photovoltaic collection system 20 comprising a concentrator 22 that focuses light from a source 24 on a focal point 26, and a photovoltaic box collector 30 at approximately the focal point 26 of the concentrator 22. The photovoltaic collector 30 has a triangular, square, or hexagonal front wall 32, a corresponding back wall 52 and a plurality of either interconnecting specularly reflective side walls 54 that form a kaleidoscope (see FIGS. 2-4). The photovoltaic collector 30 has a geometry that is easily and inexpensively constructed, while efficiently converting light into electricity.

In addition to the front wall 32 and the plurality of side walls 54 connected to sides of the front wall 32, the front wall 32 of the collector box 30 has a hole or other opening 42 therein at approximately the focal point 26 of the concentrator 22 to let the light into the collector 30. The side walls 54 interconnecting the front wall 32 and the back wall 52 generally are substantially free of solar cells 44. The inner surfaces of the side walls 54 generally are specularly reflective and reflect substantially all wavelengths with minimal or no scattering, like a mirror. In contrast to a specular reflector, a diffuse reflector scatters the incident light. The specularly reflective surfaces in the collector 30 generally can be considered to be enhanced metallic coated mirrors with a dielectric protective overcoat on the mirror surface to withstand the higher temperatures from the concentrated solar energy.

The collector box 30 defines and encloses a volume into which the only inlet and outlet for light is the hole 42 in the front wall 32. Light that enters the box 30 is captured in this volume until it is either absorbed or reflected back out the hole 42.

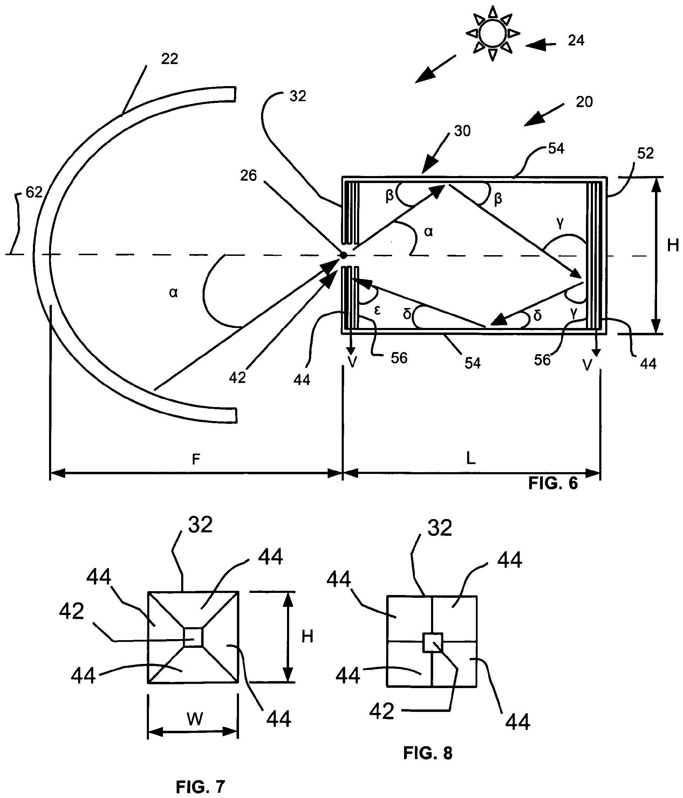

Referring to FIG. 6, at least one photovoltaic cell 44 inside the collector 30 converts the light into electricity. The photovoltaic cells 44 in the collector 30, also called PV cells or solar cells, convert light, typically but not exclusively sunlight, into electricity. Typically, the inside surface of at least the back wall 52, if not also the front wall 32, is packed with solar cells 44 tiled over the wall to substantially completely cover the surface of the wall. In addition to the side walls 54, the front wall 32 and the back wall 52 also may be specularly reflective to reflect any light that enters the spaces between and at the margins of the solar cells 44. The solar cells 44 may employ multiple junction solar cells or a spectral sampling approach, employing several different types of solar cells, to convert a wider range of wavelengths of light into electricity. Several factors are relevant in the efficiency of this conversion process, including the intensity of the light, the sensitivity of the solar cell to a particular wavelength or wavelengths of light, and the temperature of the solar cell.

As a general rule, solar cells produce more electricity when illuminated by more light, and the concentrator 22 increases the intensity by collecting and focusing more light into the collector 30. The intensity of the light is measured in Watts per unit of area, such as square meters. The same solar cell with a square meter of surface area typically will produce more electricity from two Watts of incident light than from one Watt. An exemplary concentrator 22 includes a lens, such as a Fresnel lens, or a parabolic reflector, but the concentrator 22 may include other light concentrators or a combination of light concentrators. And while the system 20 also may include other optical elements between the light source 24 and the inside of the collector 30, a secondary concentrator is optional and can be omitted.

The system 20 also may include a support and orientation assembly 55 (FIG. 1) to support the concentrator 22 and the collector 30 and tend to maintain a desired orientation of the concentrator 22 and the collector 30 relative to the light source 24. For a lens-type concentrator, the light source 24 generally is on an opposite side of the concentrator 22 from the collector 30. And for a reflective-type concentrator, the light source 24 and the collector 30 generally are on the same side as the concentrator 22.

Finally, solar cells generally convert some wavelengths of light into electricity more efficiently than other wavelengths of light. Wavelengths that are not as efficiently converted into electricity may still be absorbed the solar cell, however, producing heat and raising the temperature of the solar cell. Solar cells also are more efficient when kept relatively cool. So to minimize or eliminate the need to cool the solar cell 44, the collector 30 may include a spectral filter 56 placed over the solar cell 44 to selectively transmit ranges or bands of wavelengths of light to the solar cell 44 while reflecting wavelengths outside the selected band. This way the solar cell 44 will be illuminated with more of the wavelengths that it can efficiently convert to electricity and less of the wavelengths that create relatively more heat than electricity. An exemplary spectral filter 56 is a Rugate filter. Additionally, by using different types of solar cells, each of which is more efficient at converting different selected bands of wavelengths, a wider range of wavelengths can be effectively converted into electricity.

The kaleidoscope box collector 30 of FIGS. 2 and 6 has a square front wall 32, a square back wall 52 and four side walls 54 perpendicular to and interconnecting the front wall 32 and the back wall 52, with its cross-section parallel to the front wall 32 and the back wall 52. Since solar cells typically are square or rectangular, a square shape generally can be tiled to cover substantially the entire surface of a square relatively easily. Alternatively, the collector 30 can have triangular (FIG. 3) or hexagonal (FIG. 4) cross-sections and triangular or hexagonal front and back walls 32 and 52, respectively, as mentioned above. The opening 42 typically is centered in the front wall 32, and may have a circular shape, as in FIG. 2. Alternatively, the opening 42 may have a non-circular shape. For example, in FIGS. 3, 4, and 8 the opening 42 has a shape and orientation that corresponds to the shape and orientation of the front wall 32. The orientation of the non-circular opening 42 is not limited to the corresponding orientation of the shape of the front wall 32, however.

The back wall 52 has substantially the same size or orientation, when compared to the front wall 32. The triangular, square, and hexagonal front wall 32 and back wall 52, and the specularly reflective side walls 54 produce uniform illumination patterns on the front wall 32 and the back wall 52. No rotationally symmetric shape or other n-sided shape has been found that provides uniform illumination.

These collector designs have many benefits. For example, the solar cells can be packed efficiently on the illuminated surface to minimize packing-fraction loss, or losses in the spaces between and at the margins of the solar cells. In addition, these collector designs can be manufactured at a relatively low cost because the components are all relatively inexpensive, and the geometry is relatively simple and easy to manufacture without tight tolerances. Also, the angles of incidence at which the light arrives at the spectral filters 56 are limited and generally match the f-number of the concentrator 22.

Referring again to FIG. 6, an exemplary system is shown with a parabolic mirror as the concentrator 22. The interior side walls 54 are specularly reflective and the end walls 32 and 52 are covered with multiple types of solar cells 44 that absorb different wavelengths of light for efficient conversion of those wavelengths into electricity. The different types of solar cells can be arranged over the surface of the front wall 32 in different ways, and two examples are shown in FIGS. 7 and 8. Other variations are possible as well.

An exemplary ray trace is shown in FIG. 6. In this example, the concentrator 22 and the collector 30 are aligned along a common axis 62 with the focal point 26 of the concentrator on the axis 62. Light reflected from the concentrator 22 passes through the focal point 26 and the hole 42 into the collector 30. This light ray will have an angle (a) relative to the axis 62. This exemplary light ray is then substantially entirely reflected from the side wall 54 at an angle (B) and then is incident on the spectral filter 56 on the back wall 52. Assuming that the wavelength of the light does not match the bandpass wavelength of the spectral filter 56, the light is substantially entirely reflected from the spectral filter 56 and an angle (g). The light is then incident on and substantially entirely reflected from the side wall 54 at an angle (d) before arriving at the spectral filter 56 over the front wall 32 at an angle (e). Assuming this time that the wavelength of light does match the bandpass wavelength of the spectral filter 56, the light passes substantially entirely through the filter 56 to the underlying solar cell 44 for conversion to electricity that can be drawn from the solar cell 44 as a voltage (V) across the solar cell 44.

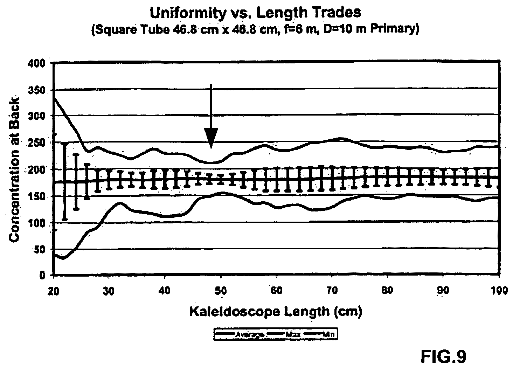

A regular square kaleidoscope box collector 32 has a length, L, a width, W, and a height, H, where the height equals the width. As shown in the chart of FIG. 9, for a kaleidoscope box collector 30 with a 46.8 centimeter-square front wall 32 (H x W) and a back wall 52 parallel to the front wall 32 and having the same size and orientation as the front wall 32, and a parabolic mirror concentrator 22 having f=6 meters and D=10 meters, a fifty-centimeter-long (L) kaleidoscope box collector 30 has the best irradiance distribution. In this configuration we found that the solar cells 44 on the back wall 52 are uniformly illuminated, with a standard deviation divided by average concentration on the back wall of about five percent.

U.S. Patent No. 6,689,949, briefly discussed in the Background, discloses a system that concentrates light using a parabolic dish reflector as a primary concentrator and a sapphire secondary concentrator with an injector into a hollow, faceted sphere. The inside surfaces of the sphere include different types of solar cells, and spectral filters in front of the solar cells reflect unwanted wavelengths. The '949 patent intends for the reflected wavelengths to be repeatedly reflected until incident on a different type of solar cell, one that is more efficient at converting that wavelength of light into electricity.

The system described in the '949 patent includes several undesirable features, however. First, the system described in the '949 patent is very expensive. The construction of a faceted sphere is difficult and requires strict tolerances on all dimensions, which makes the construction process more expensive, and the sapphire secondary concentrator is an expensive component by itself. The system provided by the present invention can be manufactured at a relatively lower cost because the sapphire injector is not needed and the geometry is much simpler and easier to manufacture with looser tolerances. And second, the system described in the '949 patent also is not easily scaled to provide different levels of maximum electricity generation. The '949 patent has non-square facets, so the packing of square solar cells requires a new layout if the facet size is changed. Placing solar cells on square facets allows integer scaling of the facets without a major change in the layout of the solar cells. The system 20 provided by the present invention also is more easily scaleable because the size of the collector 30 is not limited by the size of the concentrator 22, unlike the system described in the '949 patent.

Two other factors that contribute to the efficiency of a concentrating photovoltaic collector include uniformity of the illumination intensity across the surface of the solar cell and bandpass shifts in the spectral filters from the angle of incidence.

Solar cells generally produce more electricity from a given amount of light if that light is distributed more uniformly over the surface of the solar cell. If a solar cell with a square meter of surface area is uniformly illuminated by one Watt of light, for example, it will produce more electricity than when that same solar cell is illuminated by one Watt of light concentrated in a smaller area of the solar cell. Published raytrace simulations show that the system described in the '949 patent fails to uniformly illuminate the surface of each solar cell, preventing the solar cells from generating electricity at peak efficiency.

And finally, the faceted sphere described in the '949 patent does not control the angles of incidence for the light incident on the spectral filters. The band of wavelengths transmitted through a spectral filter generally shifts with the angle of incidence. So if the angle of incidence is not restricted to a narrow range of angles, the spectral filter cannot effectively control the band of wavelengths transmitted to the solar cell. The '949 patent uses diffuse reflectors to form essentially an integrating sphere where every point inside the sphere is illuminated by all other points within the sphere. Since each solar cell inside the sphere is illuminated by a full hemisphere of light, the maximum angle hitting the spectral filters is ninety degrees.

The system 20 provided by the present invention controls the angles of incidence on the spectral filters 56 as a function of the focal length of the concentrator 22 and the design of the collector 30. For collectors 30 such as those shown in FIGS. 2-4, the maximum angle of light entering the box relative to the axis of the box is the maximum angle of illumination. The collector 30 is designed to use specular reflectors that prevent or minimize diffuse reflections from the side walls 54 that would increase these angles, thus the collector 30 provided by the present invention provides more uniform illumination of the front and back surfaces 32 and 52, respectively, inside the collector 30. Angles of incidence onto the spectral filters 56 in front of the solar cells 44 also are minimized because the side walls 54 are specularly reflective. The low angles of incidence minimize bandpass shifts to maximize the solar cells' 44 conversion of the desired wavelengths into electrical energy.

## Claims

1. A concentrating photovoltaic collection system (20) comprising a concentrator (22) that focuses incident light at a focal point (26), and a photovoltaic box collector (30) approximately at the focal point (26) that converts the light into electricity, the collector (30) having a front wall (32), a back wall (34) parallel to and spaced from the front wall (32), and a plurality of flat, specularly reflective, side walls (54) connected to sides of both the front wall (32) and the back wall (34) and perpendicular to both the front wall (32) and the back wall (34); the front wall (32) having a hole (42) located at the focal point (26) for the transmission of light into the box (30), and at least one photovoltaic cell (44) on an inside surface of the front wall (32) and at least one photovoltaic cell (44) on an inside surface of the back wall (34) to receive light and convert it into electricity,
wherein the front wall (32) and the back wall (52) have the same shapes and are either triangular, square, or hexagonal,
and wherein the front wall (32) and the back wall (52) are about the same size and have about the same orientation,
and wherein the side walls (54) interconnecting the front and back walls (32, 52) define a cross-sectional shape in a plane parallel to the front wall (32) that has the same shape as the front wall (32).

2. A system as set forth in of claim 1, wherein the inside surface of the front wall (32) is tiled with photovoltaic cells (44) to substantially completely cover the inside surface of the front wall (32).

3. A system as set forth in any of claims 1 or 2, wherein a spectral filter (56) is mounted over the photovoltaic cell (44) to pass a limited set of wavelengths of light to the photovoltaic cell (44) and to reflect other wavelengths, and the at least one photovoltaic cell (44) includes at least two photovoltaic cells (44), including at least two substantially different types of photovoltaic cells (44) that convert different wavelengths of light into electricity.

4. A system as set forth in any of claims 1-3, wherein the concentrator (22) includes a parabolic reflector or a Fresnel lens.

## Patentansprüche

1. Konzentrierendes photovoltaisches Sammelsystem (20), das einen Konzentrator (22) umfasst, der einfallendes Licht an einem Brennpunkt (26) fokussiert, und einen photovoltaischen kastenförmigen Kollektor (30) ungefähr am Brennpunkt (26) umfasst, der Licht in Elektrizität umwandelt, wobei der Kollektor (30) eine Vorderwand (32), eine zur Vorderwand (32) parallele und in einem Abstand von der Vorderwand (32) angeordnete Rückwand (34) und eine Vielzahl von flachen, spiegelähnlich reflektierenden Seitenwänden (54) aufweist, die mit Seiten von sowohl der Vorderwand (32) als auch der Rückwand (34) verbunden sind und sowohl zur Vorderwand (32) als auch zur Rückwand (34) senkrecht sind;
wobei die Vorderwand (32) ein Loch (42), das sich am Brennpunkt (26) befindet, zur Übertragung von Licht in den Kasten (30) und mindestens eine photovoltaische Zelle (44) auf einer inneren Oberfläche der Vorderwand (32) und mindestens eine photovoltaische Zelle (44) auf einer inneren Oberfläche der Rückwand (34) aufweist, um Licht zu empfangen und es in Elektrizität umzuwandeln,
wobei die Vorderwand (32) und die Rückwand (52) die gleichen Formen aufweisen und entweder dreieckig, rechteckig oder hexagonal sind
und wobei die Vorderwand (32) und die Rückwand (52) ungefähr gleich groß sind und ungefähr die gleiche Orientierung aufweisen
und wobei die Seitenwände (54), die die Vorderwand und die Rückwand (32, 52) miteinander verbinden, eine Querschnittsform in einer zur Vorderwand (32) parallelen Ebene definieren, die die gleiche Form wie die Vorderwand (32) aufweist.

2. System nach Anspruch 1, wobei die innere Oberfläche der Vorderwand (32) mit photovoltaischen Zellen (44) gekachelt ist, um im Wesentlichen die innere Oberfläche der Vorderwand (32) vollständig abzudecken.

3. System nach einem der Ansprüche 1 oder 2, wobei ein Spektralfilter (56) über der photovoltaischen Zelle (44) montiert ist, um einen beschränkten Satz von Lichtwellenlängen an die photovoltaische Zelle (44) durchzulassen und andere Wellenlängen zu reflektieren, und die mindestens eine photovoltaische Zelle (44) mindestens zwei photovoltaische Zellen (44) enthält, die mindestens zwei wesentlich verschiedene Typen von photovoltaischen Zellen (44) enthalten, die verschiedene Lichtwellenlängen in Elektrizität umwandeln.

4. System nach einem der Ansprüche 1-3, wobei der Konzentrator (22) einen parabolischen Reflektor oder eine Fresnel-Linse enthält.

## Revendications

1. Système de collecte à concentration photovoltaïque (20) comprenant un concentrateur (22) qui focalise une lumière incidente à un point focal (26), et un boîtier collecteur photovoltaïque (30) approximativement au point focal (26) qui convertit la lumière en électricité, le collecteur (30) ayant une paroi avant (32), une paroi arrière (34) parallèle à la paroi avant (32), et espacée de cette dernière, et une pluralité de parois latérales plates spéculairement réfléchissantes (54) raccordées à des côtés à la fois de la paroi avant (32) et de la paroi arrière (34) et perpendiculaires à la fois à la paroi avant (32) et à la paroi arrière (34) ; la paroi avant (32) ayant un trou (42) situé au point focal (26) pour la transmission de la lumière dans le boîtier (30) ; et au moins une cellule photovoltaïque (44) sur une surface intérieure de la paroi arrière (34) pour recevoir de la lumière et la convertir en électricité,
dans lequel la paroi avant (32) et la paroi arrière (52) ont les mêmes formes et sont soit triangulaires, soit carrées, soit hexagonales,
et dans lequel la paroi avant (32) et la paroi arrière (52) sont environ de la même taille et ont environ la même orientation,
et dans lequel les parois latérales (54) interconnectant les parois avant et arrière (32, 52) définissent une forme en coupe transversale dans un plan parallèle à la paroi avant (32) qui présente la même forme que celle de la paroi avant (32).

2. Système selon la revendication 1, dans lequel la surface intérieure de la paroi avant (32) est couverte de cellules photovoltaïques (44) pour recouvrir sensiblement complètement la surface intérieure de la paroi avant (32).

3. Système selon la revendication 1 ou 2, dans lequel un filtre spectral (56) est monté sur la cellule photovoltaïque (44) pour laisser passer un ensemble limité de longueurs d'onde de lumière jusqu'à la cellule photovoltaïque (44) et pour réfléchir d'autres longueurs d'onde, et la ou les cellules photovoltaïques (44) comprennent au moins deux cellules photovoltaïques (44), comprenant au moins deux types sensiblement différents de cellules photovoltaïques (44) qui convertissement différentes longueurs d'onde de lumière en électricité.

4. Système selon l'une quelconque des revendications 1 à 3, dans lequel le concentrateur (22) comprend un réflecteur parabolique ou une lentille de Fresnel.
